# EUROPEAN PATENT APPLICATION

(11) **EP 4 020 803 A1**
(43) Date of publication of application: **29.06.2022**
(21) Application number: 21209969.1
(22) Date of filing: 23.11.2021
(51) Int. Cl.: H03F 1/32, H03F 3/24, H03F 3/195

(54) **METHOD AND SYSTEM FOR DIGITAL FEED-FORWARD LINEARIZATION**

(30) Priority: 23.12.2020 US 202017131814
(71) Applicant: Intel Corporation, Santa Clara, CA 95054 (US)
(72) Inventor: SANCHEZ, Ramon, 28420 Galapagar MD (ES); AZADET, Kameran, San Ramon, 94583 (US)
(74) Representative: 2SPL Patentanwälte PartG mbB

(57) **Abstract**

A method and system for digital feed-forward linearization. The system includes a main transmit path and an auxiliary transmit path. The main transmit path includes circuitries configured to process a transmit signal for transmission. The main transmit path includes a power amplifier (PA) for amplifying the transmit signal. The auxiliary transmit path includes circuitries configured to generate, in a digital domain, a distortion error signal corresponding to a distortion introduced to the transmit signal due to a non-linear characteristics of the PA in the main transmit path and convert the distortion error signal to an analog distortion error signal. The analog distortion error signal is combined with an output of the PA in the main transmit path. The auxiliary transmit path comprises a PA model circuit that mimics the behavior of the PA to generate a distorted transmit signal in a digital domain.

## Description

### Field

Examples relate to signal processing, more particularly a method and system for digital feed-forward linearization.

### Background

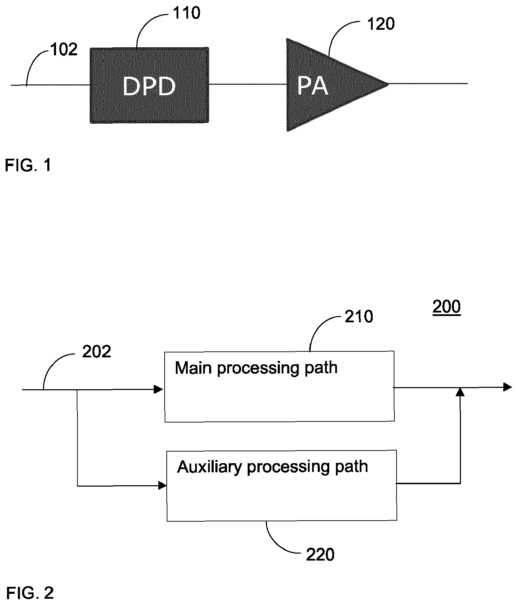

A power amplifier (PA) in a transmitter is generally non-linear and some distortion is generated at the output of the PA. Digital pre-distortion (DPD) is a technique for improving a linearity of a PA. FIG. 1 shows a schematic diagram of implementing digital pre-distortion. A DPD circuit 110 pre-distorts the input signals 102 to compensate the non-linearity introduced by the PA 120. The cascade of the DPD circuit 110 and the PA 120 becomes linear and the original input signal 102 is amplified by a constant gain. The DPD algorithm needs to model the PA behavior accurately and efficiently for proper DPD operation.

Digital pre-distortion for power amplifiers (e.g. base-station power amplifiers) becomes increasingly challenging as bandwidth of the signal increases (e.g. close to 1 GHz, with sub-6 GHz bands). Complexity of DPD increases with signal bandwidth and it may at some point make the cost prohibitive when the bandwidth is close to or higher than 1 GHz. If the power consumption of the DPD solution is too high, it may not be worth the savings in improvement of power amplifier efficiency.

As the bandwidth of the signal increases (e.g. if the signal bandwidth is greater than the fifth order intermodulation), the DPD circuit 110 has to operate at a very high sampling rate. The DPD circuit 110 can be seen as an "inverse" of the PA 120. If the transfer function of the PA 120 is H, then the transfer function of the DPD 110 is H⁻¹. If H is a finite impulse response (FIR), its inverse is infinite impulse response (IIR). Therefore, the DPD circuit 110 has more taps than the PA non-linear model.

### Brief description of the Figures

Some examples of apparatuses and/or methods will be described in the following by way of example only, and with reference to the accompanying figures, in which
FIG. 1 shows a schematic diagram of implementing digital pre-distortion;
FIG. 2 shows an example system for digital feed-forward linearization in accordance with one example;
FIG. 3 shows frequency spectrum of distorted transmit signals;
FIG. 4 shows the concept of digital feed-forward distortion cancellation in accordance with the examples disclosed herein;
FIG. 5 is a schematic diagram of a system for digital feed-forward linearization in accordance with one example;
FIG. 6 is a block diagram of an example system for digital feed-forward linearization in accordance with one example;
FIG. 7 is a flow diagram of a process of a method for digital feed-forward linearization;
FIG. 8 illustrates a user device in which the examples disclosed herein may be implemented; and
FIG. 9 illustrates a base station or infrastructure equipment radio head in which the examples disclosed herein may be implemented.

### Detailed Description

Various examples will now be described more fully with reference to the accompanying drawings in which some examples are illustrated. In the figures, the thicknesses of lines, layers and/or regions may be exaggerated for clarity.

Accordingly, while further examples are capable of various modifications and alternative forms, some particular examples thereof are shown in the figures and will subsequently be described in detail. However, this detailed description does not limit further examples to the particular forms described. Further examples may cover all modifications, equivalents, and alternatives falling within the scope of the disclosure. Like numbers refer to like or similar elements throughout the description of the figures, which may be implemented identically or in modified form when compared to one another while providing for the same or a similar functionality.

It will be understood that when an element is referred to as being "connected" or "coupled" to another element, the elements may be directly connected or coupled or via one or more intervening elements. If two elements A and B are combined using an "or", this is to be understood to disclose all possible combinations, i.e. only A, only B as well as A and B. An alternative wording for the same combinations is "at least one of A and B". The same applies for combinations of more than 2 elements.

The terminology used herein for the purpose of describing particular examples is not intended to be limiting for further examples. Whenever a singular form such as "a," "an" and "the" is used and using only a single element is neither explicitly or implicitly defined as being mandatory, further examples may also use plural elements to implement the same functionality. Likewise, when a functionality is subsequently described as being implemented using multiple elements, further examples may implement the same functionality using a single element or processing entity. It will be further understood that the terms "comprises," "comprising," "includes" and/or "including," when used, specify the presence of the stated features, integers, steps, operations, processes, acts, elements and/or components, but do not preclude the presence or addition of one or more other features, integers, steps, operations, processes, acts, elements, components and/or any group thereof.

Unless otherwise defined, all terms (including technical and scientific terms) are used herein in their ordinary meaning of the art to which the examples belong.

Examples are disclosed for digital feed-forward linearization of a PA. In examples, two transmitters (two transmit paths) are combined to produce a linearized spectrum at the output of a PA. Hereafter, the terms "transmitter" and "transmit path" will be used interchangeably. In examples, a non-linearity of the PA in the main transmitter is determined (e.g. indirectly) in a digital domain using an observation path. An auxiliary transmitter that mimics the non-linearity of the PA is used to generate the non-linear distortion in the PA output and the non-linear distortion is subtracted from the PA output to cancel the non-linear distortion of the PA in a digital feed-forward manner.

FIG. 2 shows an example system 200 for digital feed-forward linearization in accordance with one example. The system 200 includes a main transmit path 210 and an auxiliary transmit path 220. The main transmit path 210 includes circuitries configured to process a transmit signal 202 for transmission such as a modulator, a digital-to-analog converter (DAC), a mixer, a filter, and a PA, etc. The PA in the main transmit path 210 amplifies the transmit signal 202. The auxiliary transmit path 220 includes circuitries configured to generate, in a digital domain, a distortion error signal corresponding to a distortion introduced to the transmit signal in the main transmit path 210 due to non-linear characteristics of the PA in the main transmit path 210. The auxiliary processing path 220 is configured to convert the distortion error signal to an analog distortion error signal, and the analog distortion error signal is combined (e.g. subtracted) with an output of the PA in the main transmit path 210 to cancel the distortion from the distorted transmit signal. The distortion error signal may have an opposite polarity to the distortion introduced to the transmit signal such that the analog distortion error signal may be added to the PA output signal to cancel out the distortion in the PA output.

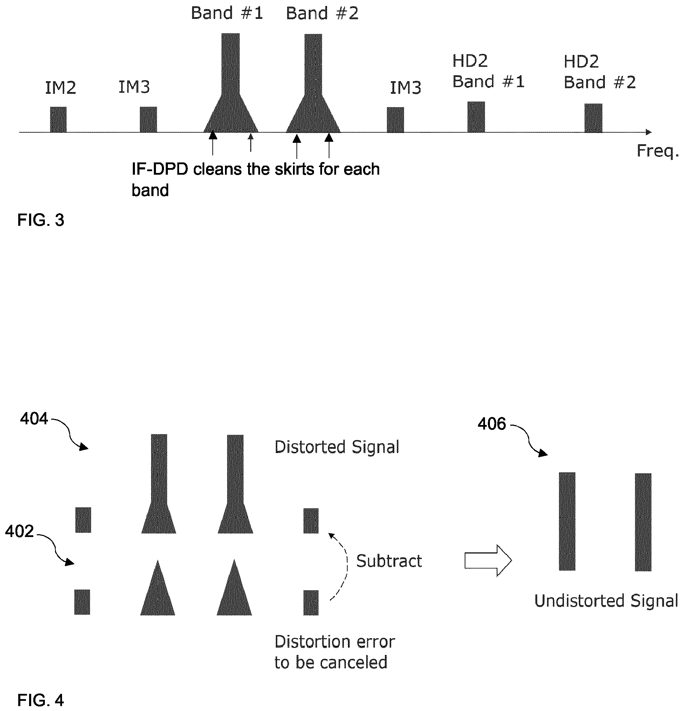

FIG. 3 shows frequency spectrum of distorted transmit signals (e.g. band 1 and band 2) and second and third order intermodulation (IM) and second order harmonic distortions (HD). Intermediate frequency DPD (IF-DPD) cleans only the skirts of each band of interest (e.g. band 1 and band 2 in this example). Radio frequency DPD (RF-DPD) may clean the whole spectrum, but the DPD has to operate at a high sampling rate.

FIG. 4 shows the concept of digital feed-forward distortion cancellation in accordance with the examples disclosed herein. The distortion error signal 402 is generated in a digital domain in the auxiliary transmit path 220 and subtracted from the distorted transmit signal 404 in an analog domain in the main transmit path 210 to generate an undistorted transmit signal 406. The distortion error signal is in an opposite polarity to the distortion incurred by the PA in the main transmit path 210 and the distortion error signal is combined with the PA output signal to cancel out the distortion incurred in the transmit signal in the main transmit path 210.

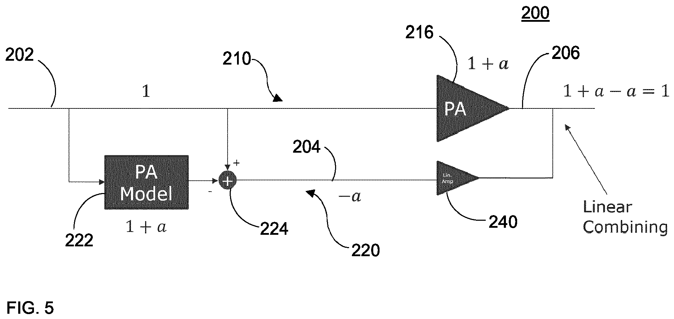

FIG. 5 is a schematic diagram of a system 200 for digital feed-forward linearization in accordance with one example. The system 200 includes a main transmit path 210 and an auxiliary transmit path 220. The main transmit path 210 includes a PA 216 for amplifying a transmit signal 202. If the transfer function of the PA is '1+*a*', the output of the PA for an input of' 1' should be '1+*a*'.

The auxiliary transmit path 220 includes a PA model circuit 222. The PA model circuit 222 mimics the behavior of the PA 216 in the main transmit path 210. The PA model circuit 222 receives the transmit signal 202 and introduces the same non-linear distortion to the transmit signal 202 as the PA 216 does. The output of the PA model circuit 222 would be '1+*a*'. The output of the PA model circuit 222 is subtracted by the combiner 224 (a subtractor in this example) from the transmit signal 202 to generate a distortion error signal 204 (-*a* in this example). In this example, the distortion error signal 204 is in an opposite polarity of the PA distortion. The distortion error signal 204 is amplified by a linear amplifier 240 for proper scaling and then combined (e.g. added) with the PA output signal 206. By combining the distortion error signal 204 (-*a*) with the PA output signal 206 (1+*a*), the distortion component is cancelled from the PA output in the main transmit path 210.

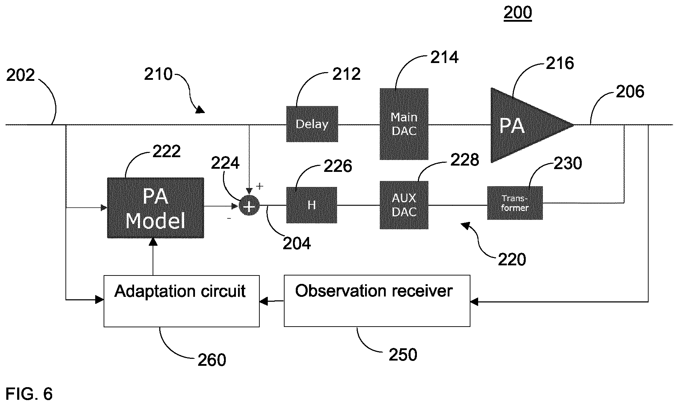

FIG. 6 is a block diagram of an example system 200 for digital feed-forward linearization in accordance with one example. The system 200 includes a main transmit path 210 and an auxiliary transmit path 220. The main transmit path 210 includes circuitries configured to process a transmit signal 202 for transmission. The transmit signal 202 is converted to an analog signal by a DAC 214 and then amplified by the PA 216.

The auxiliary transmit path 220 includes circuitries configured to generate the distortion error signal. The auxiliary transmit path 220 includes a PA model circuit 222. The PA model circuit 222 mimics the behaviors of the PA 216. The PA model circuit 222 receives the transmit signal 202 and introduces the same non-linear distortion to the transmit signal 202 as the PA 216 does in the main transmit path 210.

The combiner 224 (a subtractor in this example) subtracts the output of the PA model circuit 222 from the transmit signal 202 to generate a distortion error signal 204. The distortion error signal 204 is in an opposite polarity of the PA distortion in the main transmit path 210. In the examples, the distortion error signal 204 is generated in a digital domain.

The auxiliary processing path 220 includes an adjustment circuit 226 for adjusting a gain on the distortion error signal 204. A gain of the distortion error signal 204 is adjusted so that the distortion in the transmit signal in the main transmit path 210 is properly cancelled. The adjustment circuit 226 may also modify the distortion error signal 204 to account for a linear frequency response of the PA 216.

The adjustment circuit 226 may also introduce a delay to the distortion error signal 204 for synchronization of the distortion error signal in the auxiliary transmit path 220 with the transmit signal in the main transmit path 210. The main transmit path 210 may also include a delay circuit 212 to introduce a delay to the transmit signal for synchronization with the distortion error signal.

The distortion error signal 204 is converted to an analog signal by the DAC 228 (auxiliary DAC) in the auxiliary transmit path 220 and then combined with the output of the PA 216 in the main transmit path 210. The auxiliary transmit path 220 may include a transformer 230 for coupling the analog distortion error signal to the output of the PA 216. The transformer 230 may protect the output of the DAC 228 in the auxiliary transmit path 220 from the high voltage at the PA output in the main transmit path 210.

The PA model circuit 222 may be implemented with a digital filter (e.g. an FIR filter), and the filter coefficients may be determined adaptatively based on a feedback signal. The system 200 may include an observation receiver 250. The PA output may be tapped onto an observation path and the observation receiver 250 may down-convert and digitize it and provide a feedback signal to the adaptation circuit 260. The adaptation circuit 260 may adaptatively determine the filter coefficients for the PA model circuit 222 based on the feedback signal and the transmit signal using any convention al adaptation algorithm (e.g. least mean square (LMS), etc.).

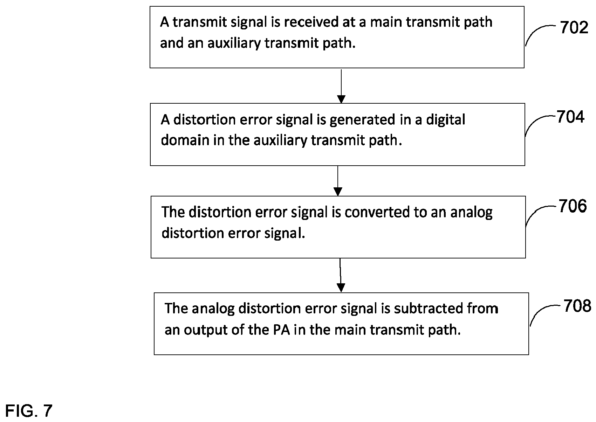

FIG. 7 is a flow diagram of a process 700 of a method for digital feed-forward linearization. A transmit signal is received at a main transmit path and an auxiliary transmit path (702). The transmit signal is processed by the main transmit path including amplification by a PA. A distortion error signal is generated in a digital domain in the auxiliary transmit path (704). The distortion error signal corresponds to a distortion introduced to the transmit signal in the main transmit path due to a non-linear characteristics of the PA. The distortion error signal is converted to an analog distortion error signal (706). A gain and delay of the distortion error signal may be adjusted for proper cancellation of the distortion. The distortion error signal may also be modified to account for a linear frequency response of the PA. The analog distortion error signal is subtracted from an output of the PA in the main transmit path (708). The analog distortion error signal may be combined with the output of the PA via a transformer.

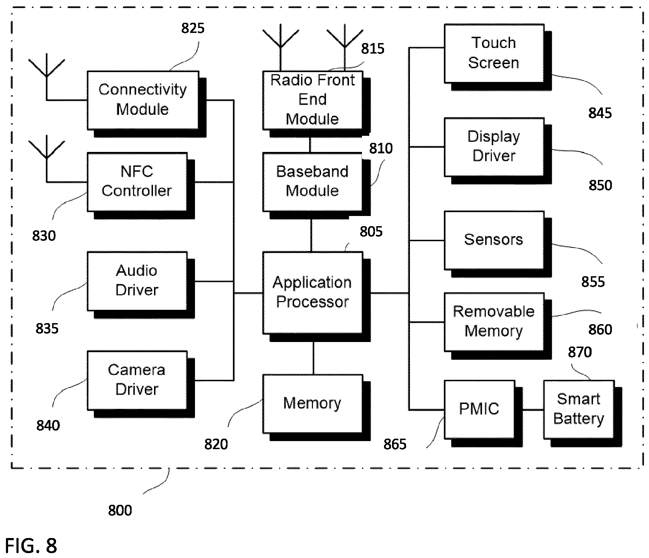

FIG. 8 illustrates a user device 800 in which the examples disclosed herein may be implemented. For example, the examples disclosed herein may be implemented in the radio front-end module 815, in the baseband module 810, etc. The user device 800 may be a mobile device in some aspects and includes an application processor 805, baseband processor 810 (also referred to as a baseband module), radio front end module (RFEM) 815, memory 820, connectivity module 825, near field communication (NFC) controller 830, audio driver 835, camera driver 840, touch screen 845, display driver 850, sensors 855, removable memory 860, power management integrated circuit (PMIC) 865 and smart battery 870.

In some aspects, application processor 805 may include, for example, one or more CPU cores and one or more of cache memory, low drop-out voltage regulators (LDOs), interrupt controllers, serial interfaces such as serial peripheral interface (SPI), inter-integrated circuit (I²C) or universal programmable serial interface module, real time clock (RTC), timer-counters including interval and watchdog timers, general purpose input-output (IO), memory card controllers such as secure digital / multi-media card (SD/MMC) or similar, universal serial bus (USB) interfaces, mobile industry processor interface (MIPI) interfaces and Joint Test Access Group (JTAG) test access ports.

In some aspects, baseband module 810 may be implemented, for example, as a solder-down substrate including one or more integrated circuits, a single packaged integrated circuit soldered to a main circuit board, and/or a multi-chip module containing two or more integrated circuits.

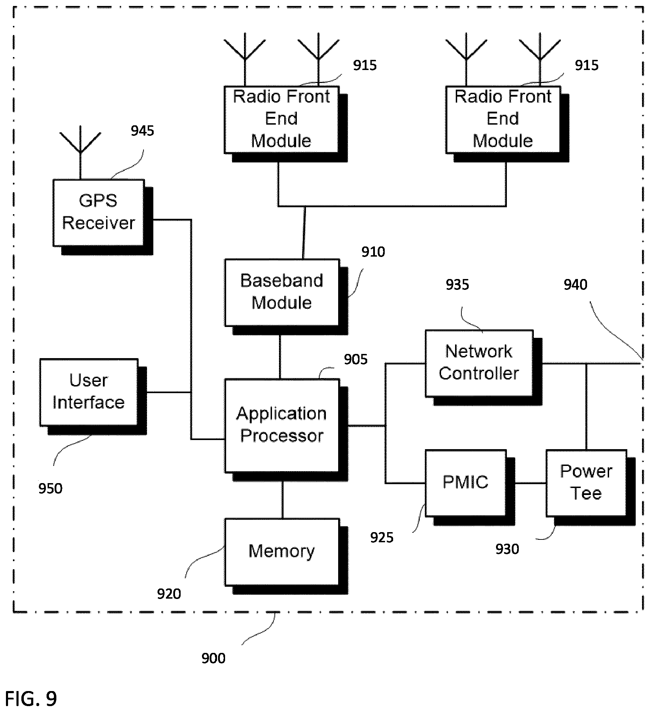

FIG. 9 illustrates a base station or infrastructure equipment radio head 900 in which the examples disclosed herein may be implemented. For example, the examples disclosed herein may be implemented in the radio front-end module 915, in the baseband module 910, etc. The base station radio head 900 may include one or more of application processor 905, baseband modules 910, one or more radio front end modules 915, memory 920, power management circuitry 925, power tee circuitry 930, network controller 935, network interface connector 940, satellite navigation receiver module 945, and user interface 950.

In some aspects, application processor 905 may include one or more CPU cores and one or more of cache memory, low drop-out voltage regulators (LDOs), interrupt controllers, serial interfaces such as SPI, I²C or universal programmable serial interface module, real time clock (RTC), timer-counters including interval and watchdog timers, general purpose IO, memory card controllers such as SD/MMC or similar, USB interfaces, MIPI interfaces and Joint Test Access Group (JTAG) test access ports.

In some aspects, baseband processor 910 may be implemented, for example, as a solder-down substrate including one or more integrated circuits, a single packaged integrated circuit soldered to a main circuit board or a multi-chip module containing two or more integrated circuits.

In some aspects, memory 920 may include one or more of volatile memory including dynamic random access memory (DRAM) and/or synchronous dynamic random access memory (SDRAM), and nonvolatile memory (NVM) including high-speed electrically erasable memory (commonly referred to as Flash memory), phase change random access memory (PRAM), magneto resistive random access memory (MRAM) and/or a three-dimensional crosspoint memory. Memory 920 may be implemented as one or more of solder down packaged integrated circuits, socketed memory modules and plug-in memory cards.

In some aspects, power management integrated circuitry 925 may include one or more of voltage regulators, surge protectors, power alarm detection circuitry and one or more backup power sources such as a battery or capacitor. Power alarm detection circuitry may detect one or more of brown out (under-voltage) and surge (over-voltage) conditions.

In some aspects, power tee circuitry 930 may provide for electrical power drawn from a network cable to provide both power supply and data connectivity to the base station radio head 900 using a single cable.

In some aspects, network controller 935 may provide connectivity to a network using a standard network interface protocol such as Ethernet. Network connectivity may be provided using a physical connection which is one of electrical (commonly referred to as copper interconnect), optical or wireless.

In some aspects, satellite navigation receiver module 945 may include circuitry to receive and decode signals transmitted by one or more navigation satellite constellations such as the global positioning system (GPS), Globalnaya Navigatsionnaya Sputnikovaya Sistema (GLONASS), Galileo and/or BeiDou. The receiver 945 may provide data to application processor 905 which may include one or more of position data or time data. Application processor 905 may use time data to synchronize operations with other radio base stations.

In some aspects, user interface 950 may include one or more of physical or virtual buttons, such as a reset button, one or more indicators such as light emitting diodes (LEDs) and a display screen.

Another example is a computer program having a program code for performing at least one of the methods described herein, when the computer program is executed on a computer, a processor, or a programmable hardware component. Another example is a machine-readable storage including machine readable instructions, when executed, to implement a method or realize an apparatus as described herein. A further example is a machine-readable medium including code, when executed, to cause a machine to perform any of the methods described herein.

The examples as described herein may be summarized as follows:

Example 1 is a system for digital feed-forward linearization. The system may include a main transmit path and an auxiliary transmit path. The main transmit path includes circuitries configured to process a transmit signal for transmission. The main transmit path includes a power amplifier (PA) for amplifying the transmit signal. The auxiliary transmit path includes circuitries configured to generate, in a digital domain, a distortion error signal corresponding to a distortion introduced to the transmit signal due to a non-linear characteristics of the PA in the main transmit path and convert the distortion error signal to an analog distortion error signal. The analog distortion error signal is combined with an output of the PA in the main transmit path.

Example 2 is the system of example 1, wherein the auxiliary transmit path includes a PA model circuit configured to receive the transmit signal and generate a distorted transmit signal in a digital domain. The PA model circuit is configured to introduce to the transmit signal the distortion incurred due to the non-linear characteristics of the PA. The auxiliary transmit path also includes a combiner circuit configured to subtract, in the digital domain, an output of the PA model circuit from the transmit signal to generate the distortion error signal.

Example 3 is the system as in any one of examples 1-2, wherein the auxiliary transmit path further comprises a transformer for coupling the analog distortion error signal to the output of the PA.

Example 4 is the system as in any one of examples 1-3, wherein the auxiliary transmit path further comprises an adjustment circuit configured to adjust a gain of the distortion error signal.

Example 5 is the system of example 4, wherein the adjustment circuit is configured to modify the distortion error signal to account for a linear frequency response of the PA.

Example 6 is the system as in any one of examples 4-5, wherein the adjustment circuit is configured to introduce a delay to the distortion error signal.

Example 7 is the system as in any one of examples 1-6, wherein the main transmit path further comprises a delay circuit configured to introduce a delay to the transmit signal.

Example 8 is the system as in any one of examples 1-7, wherein the auxiliary transmit path further comprises a linear amplifier configured to amplify the analog distortion error signal.

Example 9 is the system as in any one of examples 1-8 further comprising an observation receiver configured to generate a feedback signal based on the output of the PA, and an adaptation circuit configured to generate coefficients for the PA model circuit based on the feedback signal and the transmit signal.

Example 10 is a system for digital feed-forward linearization. the system includes a PA model circuit configured to receive a transmit signal and generate a distorted transmit signal in a digital domain by introducing a distortion introduced to the transmit signal by a PA due to a non-linear characteristics of the PA, and a combiner circuit configured to subtract, in the digital domain, an output of the PA model circuit from the transmit signal to generate a distortion error signal. The distortion error signal is converted to an analog distortion error signal and combined with an output of the PA.

Example 11 is the system of example 10, further comprising an adjustment circuit configured to adjust a gain of the distortion error signal.

Example 12 is the system of example 11, wherein the adjustment circuit is configured to modify the distortion error signal to account for a linear frequency response of the PA.

Example 13 is the system as in any one of examples 11-12, wherein the adjustment circuit is configured to introduce a delay to the distortion error signal.

Example 14 is a method for digital feed-forward linearization. The method includes receiving a transmit signal, generating, in a digital domain, a distortion error signal corresponding to a distortion introduced to the transmit signal due to a non-linear characteristics of a PA, converting the distortion error signal to an analog distortion error signal, and subtracting the analog distortion error signal from an output of the PA.

Example 15 is the method of example 14, wherein the analog distortion error signal is combined with the output of the PA via a transformer.

Example 16 is the method as in any one of examples 14-15, further comprising adjusting a gain of the distortion error signal.

Example 17 is the method as in any one of examples 14-16, further comprising modifying the distortion error signal to account for a linear frequency response of the PA.

The aspects and features mentioned and described together with one or more of the previously detailed examples and figures, may as well be combined with one or more of the other examples in order to replace a like feature of the other example or in order to additionally introduce the feature to the other example.

Examples may further be or relate to a computer program having a program code for performing one or more of the above methods, when the computer program is executed on a computer or processor. Steps, operations or processes of various above-described methods may be performed by programmed computers or processors. Examples may also cover program storage devices such as digital data storage media, which are machine, processor or computer readable and encode machine-executable, processor-executable or computer-executable programs of instructions. The instructions perform or cause performing some or all of the acts of the above-described methods. The program storage devices may comprise or be, for instance, digital memories, magnetic storage media such as magnetic disks and magnetic tapes, hard drives, or optically readable digital data storage media. Further examples may also cover computers, processors or control units programmed to perform the acts of the above-described methods or (field) programmable logic arrays ((F)PLAs) or (field) programmable gate arrays ((F)PGAs), programmed to perform the acts of the above-described methods.

The description and drawings merely illustrate the principles of the disclosure. Furthermore, all examples recited herein are principally intended expressly to be only for pedagogical purposes to aid the reader in understanding the principles of the disclosure and the concepts contributed by the inventor(s) to furthering the art. All statements herein reciting principles, aspects, and examples of the disclosure, as well as specific examples thereof, are intended to encompass equivalents thereof.

A functional block denoted as "means for ..." performing a certain function may refer to a circuit that is configured to perform a certain function. Hence, a "means for s.th." may be implemented as a "means configured to or suited for s.th.", such as a device or a circuit configured to or suited for the respective task.

Functions of various elements shown in the figures, including any functional blocks labeled as "means", "means for providing a sensor signal", "means for generating a transmit signal.", etc., may be implemented in the form of dedicated hardware, such as "a signal provider", "a signal processing unit", "a processor", "a controller", etc. as well as hardware capable of executing software in association with appropriate software. When provided by a processor, the functions may be provided by a single dedicated processor, by a single shared processor, or by a plurality of individual processors, some of which or all of which may be shared. However, the term "processor" or "controller" is by far not limited to hardware exclusively capable of executing software but may include digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

A block diagram may, for instance, illustrate a high-level circuit diagram implementing the principles of the disclosure. Similarly, a flow chart, a flow diagram, a state transition diagram, a pseudo code, and the like may represent various processes, operations or steps, which may, for instance, be substantially represented in computer readable medium and so executed by a computer or processor, whether or not such computer or processor is explicitly shown. Methods disclosed in the specification or in the claims may be implemented by a device having means for performing each of the respective acts of these methods.

It is to be understood that the disclosure of multiple acts, processes, operations, steps or functions disclosed in the specification or claims may not be construed as to be within the specific order, unless explicitly or implicitly stated otherwise, for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, -processes, -operations or -steps, respectively. Such sub acts may be included and part of the disclosure of this single act unless explicitly excluded.

Furthermore, the following claims are hereby incorporated into the detailed description, where each claim may stand on its own as a separate example. While each claim may stand on its own as a separate example, it is to be noted that - although a dependent claim may refer in the claims to a specific combination with one or more other claims - other examples may also include a combination of the dependent claim with the subject matter of each other dependent or independent claim. Such combinations are explicitly proposed herein unless it is stated that a specific combination is not intended. Furthermore, it is intended to include also features of a claim to any other independent claim even if this claim is not directly made dependent to the independent claim.

## Claims

1. A system for digital feed-forward linearization, comprising:
a main transmit path including circuitries configured to process a transmit signal for transmission, the main transmit path including a power amplifier, PA, for amplifying the transmit signal; and
an auxiliary transmit path including circuitries configured to generate, in a digital domain, a distortion error signal corresponding to a distortion introduced to the transmit signal due to a non-linear characteristics of the PA in the main transmit path and convert the distortion error signal to an analog distortion error signal, wherein the analog distortion error signal is combined with an output of the PA in the main transmit path.

2. The system of claim 1, wherein the auxiliary transmit path comprises:
a PA model circuit configured to receive the transmit signal and generate a distorted transmit signal in a digital domain, wherein the PA model circuit is configured to introduce to the transmit signal the distortion incurred due to the non-linear characteristics of the PA; and
a combiner circuit configured to subtract, in the digital domain, an output of the PA model circuit from the transmit signal to generate the distortion error signal.

3. The system as in any one of claims 1-2, wherein the auxiliary transmit path further comprises a transformer for coupling the analog distortion error signal to the output of the PA.

4. The system as in any one of claims 1-3, wherein the auxiliary transmit path further comprises an adjustment circuit configured to adjust a gain of the distortion error signal.

5. The system of claim 4, wherein the adjustment circuit is configured to modify the distortion error signal to account for a linear frequency response of the PA.

6. The system as in any one of claims 4-5, wherein the adjustment circuit is configured to introduce a delay to the distortion error signal.

7. The system as in any one of claims 1-6, wherein the auxiliary transmit path further comprises a linear amplifier configured to amplify the analog distortion error signal.

8. The system as in any one of claims 1-7, further comprising:
an observation receiver configured to generate a feedback signal based on the output of the PA; and
an adaptation circuit configured to generate coefficients for the PA model circuit based on the feedback signal and the transmit signal.

9. A system for digital feed-forward linearization, comprising:
a power amplifier, PA, model circuit configured to receive a transmit signal and generate a distorted transmit signal in a digital domain by introducing a distortion introduced to the transmit signal by a PA due to a non-linear characteristics of the PA; and
a combiner circuit configured to subtract, in the digital domain, an output of the PA model circuit from the transmit signal to generate a distortion error signal, wherein the distortion error signal is converted to an analog distortion error signal and combined with an output of the PA.

10. The system of claim 9, further comprising an adjustment circuit configured to adjust a gain of the distortion error signal.

11. The system of claim 10, wherein the adjustment circuit is configured to modify the distortion error signal to account for a linear frequency response of the PA.

12. The system as in any one of claims 10-11, wherein the adjustment circuit is configured to introduce a delay to the distortion error signal.

13. A method for digital feed-forward linearization, comprising:
receiving a transmit signal;
generating, in a digital domain, a distortion error signal corresponding to a distortion introduced to the transmit signal due to a non-linear characteristics of a power amplifier (PA);
converting the distortion error signal to an analog distortion error signal; and
subtracting the analog distortion error signal from an output of the PA.

14. The method of claim 13, wherein the analog distortion error signal is combined with the output of the PA via a transformer.

15. The method as in any one of claims 13-14, further comprising:
adjusting a gain of the distortion error signal; and/or
modifying the distortion error signal to account for a linear frequency response of the PA.
